# EUROPEAN PATENT APPLICATION

(11) **EP 3 890 028 A1**
(43) Date of publication of application: **06.10.2021**
(21) Application number: 19891160.4
(22) Date of filing: 21.11.2019
(51) Int. Cl.: H01L 27/32

(54) **DISPLAY PANEL AND TERMINAL**

(30) Priority: 30.11.2018 CN 201811454286
(71) Applicant: VIVO MOBILE COMMUNICATION CO., LTD., Dongguan, Guangdong 523860 (CN)
(72) Inventor: WU, Wen, Dongguan, Guangdong 523860 (CN); ZHANG, Qiang, Dongguan, Guangdong 523860 (CN); ZHANG, Xiang, Dongguan, Guangdong 523860 (CN)
(74) Representative: Lavoix
(86) International application number: PCT/CN2019/119905
(87) International publication number: WO 2020/108372

(57) **Abstract**

A display panel and a terminal are disclosed. The display panel includes a transparent substrate; and a first display module disposed in a first area (1) of the transparent substrate and a second display module disposed in a second area (2) of the transparent substrate, where the first area (1) and the second area (2) are combined to form an entire display area, the first display module is an active matrix organic light-emitting diode AMOLED display module, and the second display module is a passive matrix organic light-emitting diode PMOLED display module.

## Description

### CROSS-REFERENCE TO RELATED APPLICATIONS

This application claims priority to Chinese Patent Application No. 201811454286.5, filed on November 30, 2018 in China, which is incorporated herein by reference in its entirety.

### TECHNICAL FIELD

The present disclosure relates to the field of electronic technology, and in particular, to a display panel and a terminal.

### BACKGROUND

With the rapid development of electronic products in recent years, mobile phones have become a shining star, and irreplaceably become the most concerned electronic products of the public. In view of the development history of Apple and several leading mobile phones, the screens are getting bigger and bigger, the appearance is getting more refined, and the mobile phones are getting thinner and lighter. However, in recent years, a bottleneck of a material of a mobile phone structure greatly restricts development of the mobile phone in an extreme direction such as ultra-thin and ultra-light. Therefore, development of various mobile phone members becomes a key to the development of the mobile phone. Mobile phone members such as high-strength, ultra-thin, curved, and bent members become the focus of the market.

A display screen of the mobile phone is a window for a consumer to feel the mobile phone. For the mobile phone, a design of a display window is particularly important. Long-term use of a 2D display screen and a 2.5D curved-glass display screen can no longer surprise consumers. Although a 3D curved screen have given consumers a strong visual impact, the 3D curved screen cannot produce a qualitative change.

A full screen is a screen design in which a screen-to-body ratio is close to 100%. An upper/left/right frame of a display module is less than 0.5 mm, a lower frame is less than 3 mm, and an active Area (Active Area, AA) far exceeds a screen-to-body ratio 80%. In a design of a full-screen mobile phone, a front screen-to-body ratio is close to 100%, and there is no position for placing an optical component such as a camera or a photosensitive component. Therefore, to place the optical component on the screen, a hole that meets a transmittance required by the optical component needs to be created directly above the optical component, so as to implement a normal function of the optical component, such as photographing, face unlocking, and photosensitive sensing.

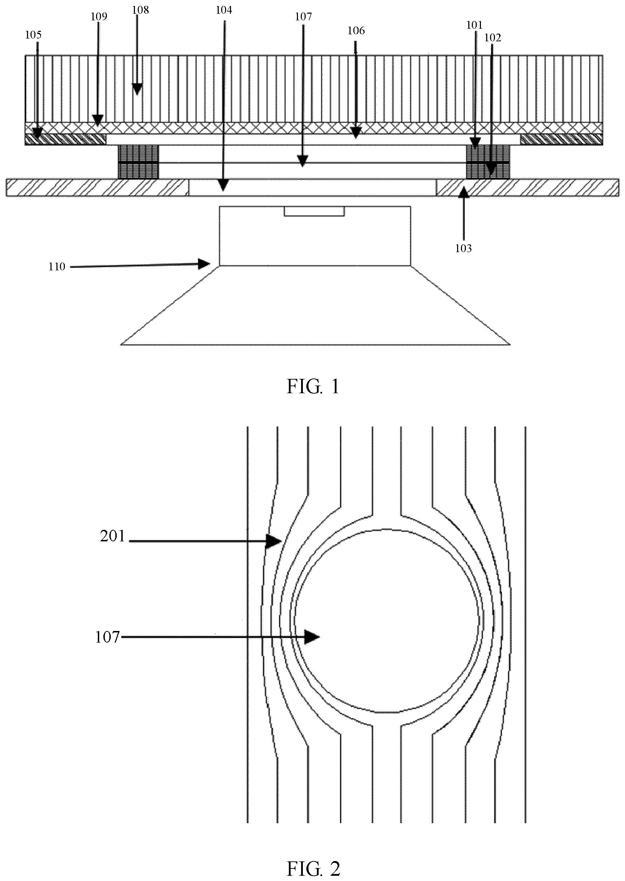

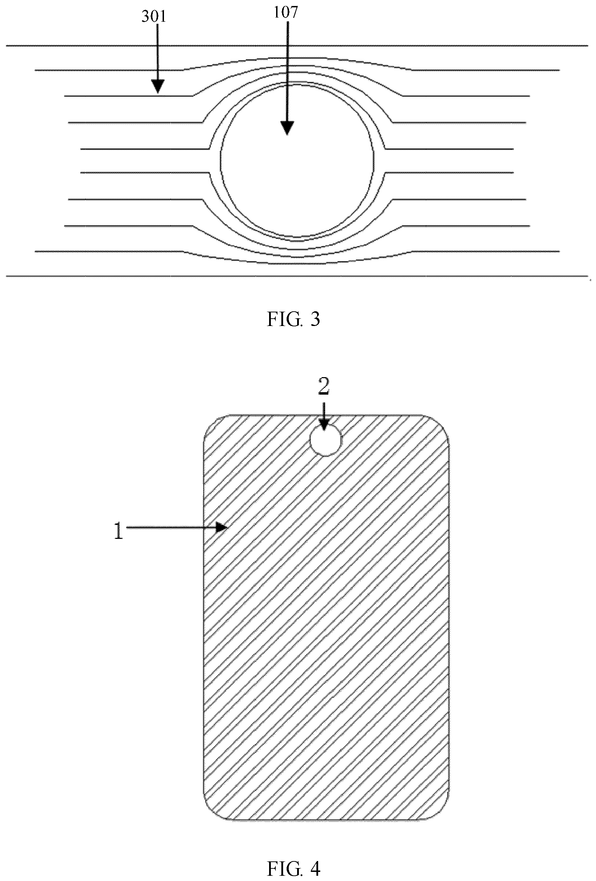

In addition, to improve a screen-to-body ratio, as shown in FIG 1 to FIG. 3, in some design solutions, metal cabling on upper glass 101 and lower glass 102 of an organic light-emitting diode (Organic Light-Emitting Diode, OLED) display screen bypasses a location area corresponding to a camera 110 (as shown in FIG. 2, a source cable 201 bypasses a location area corresponding to the camera, and as shown in FIG. 3, a horizontal gate cable bypasses 301 a location area 302 corresponding to the camera), to form a light transmission area 107. In addition, no luminescent material is evaporated on the lower glass 102, so that the upper glass and the lower glass are completely transparent. Then, a first hole 104 is provided on a protection foam 103, and a second hole 106 is provided on a polarizer 105. In addition, both a glass cover 108 and an optical clear adhesive (OCA) 109 used to bond the glass cover 108 are in a transparent state. Therefore, in the foregoing manner, a transparent area may be obtained on the OLED display screen, thereby making it possible to implement photographing.

Alternatively, to improve a screen-to-body ratio, most of OLED displays and thin film transistor (Thin Film Transistor, TFT) display modules on the market use a special-shape cutting process, thereby freeing space for an on-screen optical component.

However, the foregoing design cannot be referred to as an actual full screen, but further increases a screen-to-body ratio, because a display position corresponding to an optical component does not have a display function. It can be learned that a display screen in the related art cannot ensure a full display function on the basis of providing a light transmission condition for an optical component.

### SUMMARY

Some embodiments of the present disclosure provide a display panel and a terminal, to resolve a problem in the related art that a display screen cannot ensure a full display function on the basis of providing a light transmission condition for an optical component.

According to a first aspect, an embodiment of the present disclosure provides a display panel, including:
a transparent substrate; and
a first display module disposed in a first area of the transparent substrate and a second display module disposed in a second area of the transparent substrate, where
the first area and the second area are combined to form an entire display area, the first display module is an active matrix organic light-emitting diode AMOLED display module, and the second display module is a passive matrix organic light-emitting diode PMOLED display module.

According to a second aspect, an embodiment of the present disclosure provides a terminal, including a driving chip, at least one optical component, and the foregoing display panel, where a cathode layer and an anode layer of a passive matrix organic light-emitting diode PMOLED display module are electrically connected to the driving chip, and the optical component obtains light by using the passive matrix organic light-emitting diode PMOLED display module.

Beneficial effects of the embodiments of the present disclosure are as follows:

In some embodiments of the present disclosure, the AMOLED display module is disposed in the first area of the transparent substrate, and the PMOLED display module is disposed in the second area, so that an entire display module is formed by the AMOLED display module and the PMOLED display module, thereby jointly implementing a display function. Because the PMOLED display module has a relatively high light transmittance, the second area can not only provide a light transmission condition for the optical component, but also can cooperate with the first area for display. This resolves a problem in the related art that a display screen cannot ensure a full display function on the basis of providing the light transmission condition for the optical component.

### BRIEF DESCRIPTION OF DRAWINGS

To describe the technical solutions in embodiments of the present disclosure more clearly, the following briefly describes the accompanying drawings required for describing the embodiments of the present disclosure. Apparently, the accompanying drawings in the following description show merely some embodiments of the present disclosure, and a person of ordinary skill in the art may still derive another drawing from these accompanying drawings without creative efforts.
FIG. 1 is a schematic cross-sectional diagram of a full-screen module of an OLED in the related art;
FIG 2 is a schematic diagram of a cabling design of a source cable in an OLED box in the related art;
FIG. 3 is a schematic diagram of a cabling design of a gate cable in an OLED box in the related art;
FIG. 4 is a schematic front view of a display panel according to some embodiments of the present disclosure;
FIG. 5 is a schematic diagram 1 of an internal structure of an AMOLED display module according to some embodiments of the present disclosure;
FIG. 6 is a schematic diagram 2 of an internal structure of an AMOLED display module according to some embodiments of the present disclosure;
FIG 7 shows a translucent image of a AMOLED display module under a microscope according to some embodiments of the present disclosure; and
FIG. 8 is a schematic diagram of an internal structure of a PMOLED display module according to some embodiments of the present disclosure.

### DESCRIPTION OF EMBODIMENTS

The following clearly and completely describes the technical solutions in the embodiments of the present disclosure with reference to the accompanying drawings in the embodiments of the present disclosure. Apparently, the described embodiments are some rather than all of the embodiments of the present disclosure. All other embodiments obtained by a person of ordinary skill in the art based on the embodiments of the present disclosure without creative efforts shall fall within the protection scope of the present disclosure.

Some embodiments of the present disclosure provide a display panel. As shown in FIG. 4, the display panel includes:
a transparent substrate; and
a first display module disposed in a first area 1 of the transparent substrate and a second display module disposed in a second area 2 of the transparent substrate, where
the first area 1 and the second area 2 are combined to form an entire display area, the first display module is an active matrix organic light-emitting diode AMOLED display module, and the second display module is a passive matrix organic light-emitting diode PMOLED display module.

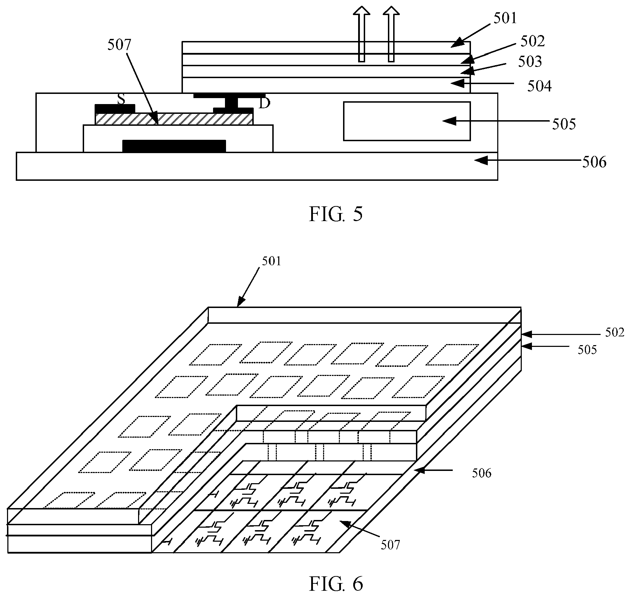

Specifically, as shown in FIG. 5 and FIG. 6, the AMOLED display module includes a cathode 501, an organic light-emitting layer 502, an anode 503, a reflection electrode 504, an insulating layer 505, a glass substrate 506, and a thin film transistor (Thin Film Transistor, TFT) drive circuit 507. The cathode of the AMOLED display module is a full-surface electrode, and an organic light-emitting material on the anode is driven by the internal TFT drive circuit to emit light. In addition, the reflection electrode is usually provided below the anode, and the reflection electrode is completely not translucent, so as to reflect the light emitted by the light-emitting material, thereby improving light utilization. In addition, metal cabling of the TFT circuit is not translucent, and the insulating layer may be translucent.

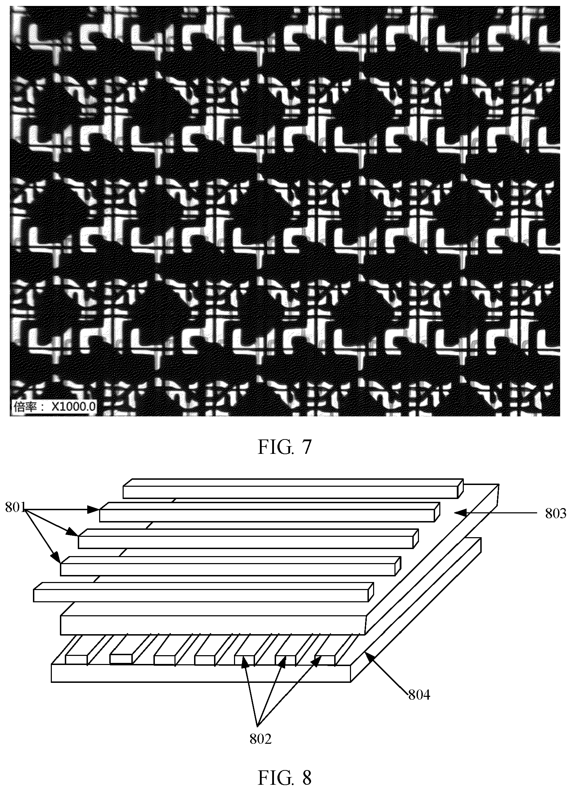

It can be learned from an internal structure of the AMOLED display module that a part of the AMOLED display module that can transmit light is a gap between metal cabling in the TFT circuit, that is, light can only pass through the gap between the metal cabling in the TFT circuit. Therefore, a light transmittance of the AMOLED display module is relatively low. Specifically, FIG. 7 shows a light transmission picture of the AMOLED display module under a microscope. A black part is an area that is completely not translucent, and a white part is a translucent area. Therefore, it can be learned that most areas of the AMOLED screen are completely not translucent, and therefore such a transmittance cannot meet a normal operation of an optical component.

Compared with the AMOLED display module, an internal structure of the PMOLED display module is simpler, and drive manners are mainly different (the AMOLED display module is an active drive, and the PMOLED display module is a passive drive). As shown in FIG. 8, the PMOLED display module includes a cathode 801, an anode 802, an organic light-emitting layer 803, and a glass substrate 804. The anode and the cathode perpendicularly form a matrix, and an intersection point between the cathode and the anode forms a pixel. A pixel in an array, that is, a light-emitting part, is lit in a scanning manner. Different from the AMOLED display module, an external drive circuit does not require a TFT circuit, but directly applies a current on a cathode layer and an anode layer, to determine which pixels emit light and which pixels do not emit light.

It can be learned from that, because the PMOLED display module does not have the reflection electrode and the TFT circuit that are not translucent, a transmittance of the PMOLED display module is greatly in increased compared with that of the AMOLED display module. Therefore, an area (that is, the second area 2) in which the PMOLED display module is disposed on the display panel in some embodiments of the present disclosure has a display function, and has a relatively high light transmittance, so that a light transmittance requirement of some optical components on a terminal can be met. Therefore, in some embodiments of the present disclosure, a problem in the related art that a display screen cannot ensure a full display function on the basis of providing a light transmission condition for an optical component is resolved.

It should be noted that internal cabling of the AMOLED display module disposed in the first area and internal cabling of the PMOLED display module disposed in the second area do not affect each other.

Optionally, the anode layer of the passive matrix organic light-emitting diode PMOLED display module is prepared by using a transparent indium tin oxide ITO material, thereby further improving a light transmittance of the PMOLED display module.

Optionally, the cathode layer of the active matrix organic light-emitting diode AMOLED display module and the cathode layer of the passive matrix organic light-emitting diode PMOLED display module are located on a same layer, thereby simplifying a process of manufacturing the display panel in some embodiments of the present disclosure. A material of the cathode layer of the AMOLED display module may also be the same as a material of the cathode layer of the PMOLED display module. Therefore, during manufacturing, the cathode layer of the AMOLED display module and the cathode layer of the PMOLED display module are laid together, thereby further simplifying the manufacturing process. When the cathode layer of the AMOLED display module and the cathode layer of the PMOLED display module are located at a same layer, there is an insulating material in a boundary area between the cathode layer of the AMOLED display module and the cathode layer of the PMOLED display module, so that the cathode layer of the AMOLED display module and the cathode layer of the PMOLED display module are separated from each other, and display functions of the two are not affected by each other.

Optionally, the anode layer of the active matrix organic light-emitting diode AMOLED display module and the anode layer of the passive matrix organic light-emitting diode PMOLED display module are located on a same layer, thereby simplifying a process of manufacturing the display panel in some embodiments of the present disclosure. When the anode layer of the AMOLED display module and the anode layer of the PMOLED display module are located at a same layer, there is an insulating material in a boundary area between the anode layer of the AMOLED display module and the anode layer of the PMOLED display module, so that the anode layer of the AMOLED display module and the anode layer of the PMOLED display module are separated from each other, and display functions of the two are not affected by each other.

Optionally, the light-emitting layer of the active matrix organic light-emitting diode AMOLED display module and the light-emitting layer of the passive matrix organic light-emitting diode PMOLED display module are located on a same layer, thereby simplifying a process of manufacturing the display panel in some embodiments of the present disclosure.

Optionally, the first area 1 is set around the second area 2. A manner of setting the first area 1 and the second area 2 is not limited thereto. For example, the first area 1 and the second area 2 may be set in a splicing form, that is, the first area 1 and the second area 2 are spliced into a complete display area.

Optionally, there are at least two second areas 2, to meet an arrangement requirement of a plurality of optical components on the terminal.

Optionally, the first area 1 forms a quadrangular shape, and the second area 2 forms a circular shape. Setting shapes of the first area 1 and the second area 2 are not limited thereto.

In view of the above, in some embodiments of the present disclosure, the AMOLED display module is disposed in the first area 1 of the transparent substrate, and the PMOLED display module is disposed in the second area 2, so that an entire display module is formed by the AMOLED display module and the PMOLED display module, thereby jointly implementing a display function. Because the PMOLED display module has a relatively high light transmittance, the second area 2 can not only provide a light transmission condition for the optical component, but also can cooperate with the first area 1 for display. This resolves a problem in the related art that a display screen cannot ensure a full display function on the basis of providing the light transmission condition for the optical component.

Some embodiments of the present disclosure further provide a terminal, including a driving chip, at least one optical component, and the foregoing display panel, where a cathode layer and an anode layer of a passive matrix organic light-emitting diode PMOLED display module are electrically connected to the driving chip, and the optical component obtains light by using the passive matrix organic light-emitting diode PMOLED display module.

Because the PMOLED display module on the display panel has a relatively high light transmittance, when the optical component is located below the PMOLED display module, light may be irradiated onto the optical component by using the PMOLED display module, so that the optical component can work normally. In addition, the PMOLED display module may further cooperate with the AMOLED display module for display. Therefore, according to the terminal in some embodiments of the present disclosure, a full screen is actually implemented on the basis of ensuring that a display area of the optical component has a display function, thereby improving an appearance effect of the entire terminal.

Specifically, the terminal in some embodiments of the present disclosure may be specifically an electronic device such as a mobile phone, a tablet computer, or a notebook computer.

The optical component includes a camera and/or a photosensitive component.

The foregoing descriptions are merely optional implementations of the present disclosure. It should be noted that a person of ordinary skill in the art may make several improvements and polishing without departing from the principle of the present disclosure and the improvements and polishing shall fall within the protection scope of the present disclosure.

## Claims

1. A display panel, comprising:
a transparent substrate; and
a first display module disposed in a first area of the transparent substrate and a second display module disposed in a second area of the transparent substrate, wherein
the first area and the second area are combined to form an entire display area, the first display module is an active matrix organic light-emitting diode AMOLED display module, and the second display module is a passive matrix organic light-emitting diode PMOLED display module.

2. The display panel according to claim 1, wherein an anode layer of the passive matrix organic light-emitting diode PMOLED display module is prepared by using a transparent indium tin oxide ITO material.

3. The display panel according to claim 1, wherein a cathode layer of the active matrix organic light-emitting diode AMOLED display module and a cathode layer of the passive matrix organic light-emitting diode PMOLED display module are located in a same layer.

4. The display panel according to claim 1, wherein an anode layer of the active matrix organic light-emitting diode AMOLED display module and an anode layer of the passive matrix organic light-emitting diode PMOLED display module are located in a same layer.

5. The display panel according to claim 1, wherein a light-emitting layer of the active matrix organic light-emitting diode AMOLED display module and a light-emitting layer of the passive matrix organic light-emitting diode PMOLED display module are located in a same layer.

6. The display panel according to claim 1, wherein the first area is set around the second area.

7. The display panel according to claim 1, wherein there are at least two second areas.

8. The display panel according to claim 1, wherein the first area forms a quadrangular shape, and the second area forms a circular shape.

9. A terminal, comprising a driving chip, at least one optical component, and the display panel according to any one of claims 1 to 8, wherein a cathode layer and an anode layer of the passive matrix organic light-emitting diode PMOLED display module are electrically connected to the driving chip; and
the optical component obtains light by using the passive matrix organic light-emitting diode PMOLED display module.

10. The terminal according to claim 9, wherein the optical component comprises a camera and/or a photosensitive component.
